# EUROPEAN PATENT APPLICATION

(11) **EP 1 892 772 A2**
(43) Date of publication of application: **27.02.2008**
(21) Application number: 07015787.0
(22) Date of filing: 10.08.2007
(51) Int. Cl.: H01L 31/12

(54) **Multi-channel photocoupling device and producing method thereof**

(30) Priority: 21.08.2006 JP 2006224284
(71) Applicant: NEC Electronics Corporation, Kawasaki, Kanagawa 211-8668 (JP)
(72) Inventor: Kanatake, Mitsutoshi, Kawaski, Kanagawa 211-8668 (JP)
(74) Representative: Glawe, Delfs, Moll

(57) **Abstract**

Provided is a photocoupling device including: a first photocoupling unit including a first light-receiving element and a first light-emitting element that are arranged to oppose each other; a second photocoupling unit including a second light-receiving element and a second light-emitting element that are arranged to oppose each other; and a lead frame including a first land portion for giving electric connection to the first light-receiving element and the first light-emitting element, and a second land portion for giving electric connection to the second light-receiving element and the second light-emitting element, in which the second photocoupling unit is mounted immediately above the first photocoupling unit mounted on the lead frame.

## Description

### BACKGROUND OF THE INVENTION

### 1. Field of the Invention

The present invention relates to a photocoupling device, and more particularly, to a multi-channel photocoupling device and a producing method thereof.

### 2. Description of Related Art

In recent years, miniaturization of various types of electronic equipment, such as communication equipment and FA devices, is advancing. Consequently, a need to miniaturize semiconductor devices used in these types of electronic equipment is intensifying (see Japanese Utility Model Examined Publication No. Hei 06-27969, JP 2002-237615 A, JP 59-229883 A, Japanese Utility Model Registration No. 61-134060, and JP 2004-214352 A). In particular, a need for miniaturization of photocouplers (photocoupling devices) is specifically strong because a plurality of photocouplers are used in combination in the electronic equipment described above.

In JP 2004-214352 A, a construction is disclosed in which separately mold-sealed photocouplers are stacked on each other. When already-existing mold-sealed photocouplers are merely stacked on each other, however, it is impossible to sufficiently achieve reduction of the overall size of the photocouplers. That is, through mold-sealing, light-receiving elements and light-emitting elements contained in the photocouplers are mechanically fixed to an inside of mold portions, with contamination from an external environment being prevented by the mold portions and breakdowns due to changes of the external environment (temperature, humidity, or the like) being also suppressed by the mold portions. However, it is required to construct the mold portions with predetermined thickness, which hinders the miniaturization of the photocouplers.

In Japanese Utility Model Examined Publication No. Hei 06-27969, a construction is disclosed in which two pairs of a light-emitting element and a light-receiving element are includedinonemoldportion. With this construction, it becomes possible to achieve reduction of the overall size of a device as compared with a case where a plurality of photocouplers each including only one pair of the light-emitting element and the light-receiving element are prepared. In Japanese Utility Model Examined Publication No. Hei 06-27969, however, a first pair of the light-emitting element and the light-receiving element is arranged in an upper portion of a lead frame for mounting the light-emitting element and a second pair of the light-emitting element and the light-receiving element is arranged in a lower portion thereof. In this case, it is required to provide mutually different electric connections to the two light-emitting elements placed on the lead frame described above. Therefore, it is required to increase a width in a planar direction of the lead frame, on which the light-emitting elements are mounted, accordingly.

### SUMMARY

In one embodiment, there is provided a photocoupling device including:a first photocoupling unit including a first light-receiving element and a first light-emitting element that are arranged to oppose each other; a second photocoupling unit including a second light-receiving element and a second light-emitting element that are arranged to oppose each other; and a lead frame including a first land portion for giving electric connection to the first light-receiving element and the first light-emitting element, and a second land portion for giving electric connection to the second light-receiving element and the second light-emitting element, in which the second photocoupling unit is mounted immediately above the first photocoupling unit mounted on the lead frame.

In another embodiment, there is provided a photocoupling device including: a first photocoupling unit constructed by arranging a first light-receiving element having a light-receiving surface and an opposing surface opposing the light-receiving surface, and a first light-emitting element having a light-emitting surface and an opposing surface opposing the light-emitting surface, to oppose each other; and a second photocoupling unit constructed by arranging a second light-receiving element having a light-receiving surface and an opposing surface opposing the light-receiving surface, and a second light-emitting element having a light-emitting surface and an opposing surface opposing the light-emitting surface, to oppose each other, in which (3) one of the opposing surface of the second light-receiving element and the opposing surface of the second light-emitting element is bonded to one of the opposing surface of the first light-receiving element and the opposing surface of the first light-emitting element.

In further another embodiment, there is provided a producing method of a photocoupling device, including: (1) preparing a first photocoupling unit including a first light-receiving element and a first light-emitting element that are arranged to oppose each other; (2) preparing a second photocoupling unit including a second light-receiving element and a second light-emitting element that are arranged to oppose each other; (3) preparing a lead frame including a first land portion for giving electric connection to the first light-receiving element and the first light-emitting element, and a second land portion for giving electric connection to the second light-receiving element and the second light-emitting element; (4) mounting the first photocoupling unit on the lead frame; and (5) mounting the second photocoupling unit immediately above the first photocoupling unit.

With the construction in which the second photocoupling unit is mounted above the first photocoupling unit, it becomes possible to sufficiently reduce the size of the photocoupling device as compared with a case where the second photocoupling unit is arranged adjacent to the first photocoupling unit. When the photocoupling device is mold-sealed, it becomes possible to achieve significant miniaturization of the photocoupling device as compared with a conventional case.

### BRIEF DESCRIPTION OF THE DRAWINGS

The above and other objects, advantages and features of the present invention will be more apparent from the following description of certain preferred embodiments taken in conjunction with the accompanying drawings, in which:
FIG. 1 is a schematic perspective view of a photocoupling device according to a first embodiment of the present invention;
FIG. 2 is a schematic cross-sectional view of the photocoupling device taken along the line A-A of FIG. 1;
FIG. 3 is a diagram for explanation of a degree of miniaturization of the photocoupling device according to the first embodiment;
FIG. 4 is a schematic perspective view of another photocoupling device according to the first embodiment;
FIG. 5 is a schematic cross-sectional view of the photocoupling device taken along the line A-A of FIG. 4;
FIG. 6 is a top view of the photocoupling device shown in FIG. 4;
FIG. 7 is a schematic cross-sectional view of the photocoupling device according to the first embodiment;
FIGS. 8A to 8D are each a diagram for explanation of production steps of the photocoupling device (photocoupling unit) according to the first embodiment;
FIGS. 9A to 9C are each a diagram for the explanation of the production steps of the photocoupling device according to the first embodiment; and
FIG. 10 is a schematic diagram of a photocoupling device according to a second embodiment of the present invention.

### DETAILED DESCRIPTION OF THE PREFERRED EMBODIMENTS

The invention will be now described herein with reference to illustrative embodiments. Those skilled in the art will recognize that many alternative embodiments can be accomplished using the teachings of the present invention and that the invention is not limited to the embodiments illustrated for explanatory purpose.

It should be noted that the same construction elements are denoted by the same reference numeral, and repetitive description will be omitted.

### <First Embodiment>

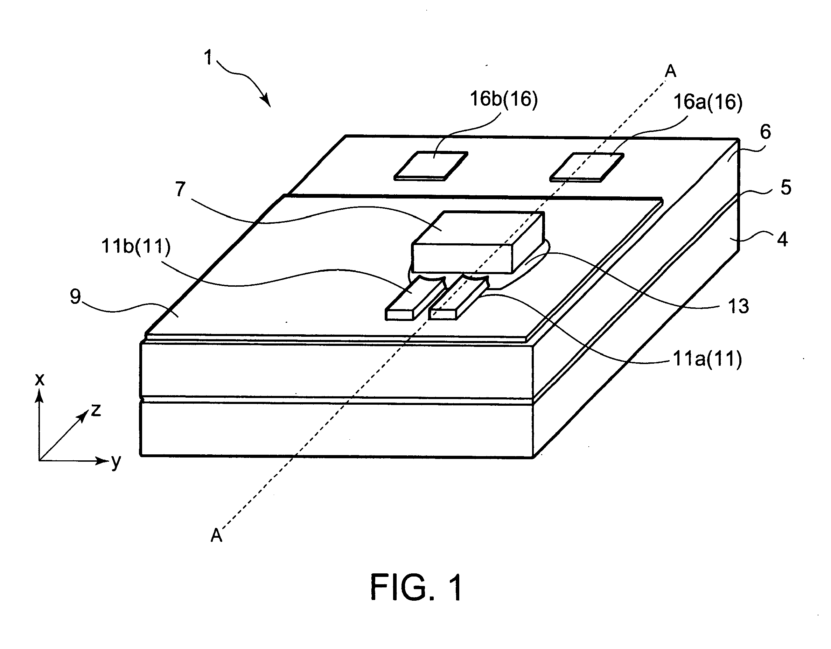

FIG. 1 is a perspective view of a photocoupling device1 according to a first embodiment. In FIG. 1, a light-receiving element 4, a bonding layer 5, a light-receiving element 6, an insulating film 9, wiring layers 11, an intermediate filling layer 13, and a light-emitting element 7 are shown. On the light-receiving element 4, the bonding layer 5, the light-receiving element 6, the insulating film 9, and the light-emitting element 7 are stacked in this order along a shown X axis.

On the insulating film 9, the wiring layers 11 are formed. Also, between the insulating film 9 and the light-emitting element 7, the intermediate filling layer 13 is filled. The light-receiving element 6 has a cathode terminal 16a and an anode terminal 16b on its surface. A wiring 11a is connected to a cathode terminal (not shown) of the light-emitting element 7 and a wiring 11b is connected to an anode terminal (not shown) of the light-emitting element 7.

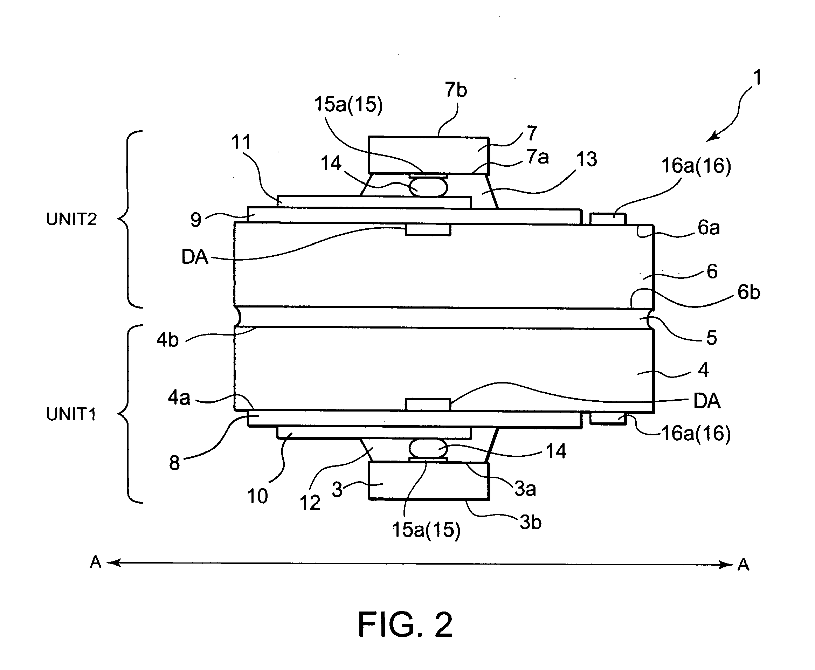

Here, a construction of the photocoupling device 1 will be described in detail with reference to FIG. 2 that is a schematic cross-sectional view taken along the line A-A shown in FIG. 1. As shown in FIG. 2, the photocoupling device 1 includes light-emitting elements 3 and 7, light-receiving elements 4 and 6, a bonding layer 5, insulating films 8 and 9, wiring layers 10 and 11, intermediate filling layers 12 and 13, and bumps 14.

The photocoupling device 1 includes a first photocoupling unit (UNIT 1). The first photocoupling unit includes the light-emitting element 3 (first light-emitting element), the light-receiving element 4 (first light-receiving element), the insulating film 8 (first insulating film), the wiring layer 10, the bump 14, and the intermediate filling layer 12 (first intermediate filling layer). Between the light-emitting element 3 and the light-receiving element 4, there are provided the insulating film 8, the wiring layer 10, and the bump 14.

The light-emitting element 3 is a light emitting diode (LED) obtained using a compound semiconductor or the like and has a light-emitting surface 3a and an opposing surface 3b opposing the light-emitting surface 3a. Also, the light-emitting element 3 has a cathode terminal 15a on the light-emitting surface 3a. A chip size of the light-emitting element 3 is smaller than that of the light-receiving element 4.

The light-receiving element 4 is a photodiode (PD) obtained using a silicon semiconductor or the like and has a light-receiving surface 4a and an opposing surface 4b opposing the light-receiving surface 4a. Also, the light-receiving element 4 has a cathode terminal 16a on the light-receiving surface4a. The light-receiving element 4 has a light-receiving region DA on a light-receiving surface 4a side. The light-receiving region DA is a PN junction constructed from an N-type epitaxial layer and a P-type region diffusion-formed in the N-type epitaxial layer, for instance.

It should be noted that detailed cross-sectional structures of the light-emitting element 3 and the light-receiving element 4 are not illustrated. In other words, an oxide layer that should exist on the light-receiving surface 4a of the light-receiving element 4 and a wiring layer and the like existing therein are omitted.

The light-emitting surface 3a of the light-emitting element 3 and the light-receiving surface 4a of the light-receiving element 4 are arranged to oppose each other. Light having a predetermined wavelength is outputted from the light-emitting surface 3a of the light-emitting element 3 and is made incident on the light-receiving surface 4a of the light-receiving element 4. In other words, an optical channel is formed between the light-emitting surface 3a of the light-emitting element 3 and the light-receiving surface 4a of the light-receiving element 4. The optical channel is formed along an axis vertically intersecting thelight-emittingsurface 3a of the light-emitting element 3 and the light-receiving surface 4a of the light-receiving element 4.

On the light-receiving surface 4a of the light-receiving element 4, the insulating film 8 is formed. The insulating film 8 is transparent with respect to the light having the predetermined wavelength given from the light-emitting element 3 to the light-receiving element 4. The insulating film 8 may be made of an insulative resin material such as polyimide, or may be made of an oxide film (SiN3, SiO2). Also, the insulating film 8 may be obtained using a sheet-shaped material such as a film.

On one surface of the insulating film 8, the wiring layer 10 is formed. On the insulating film 8, the light-emitting element 3 is implemented with the bump 14 in-between. With this construction, the light-emitting element 3 is connected to the wiring layer 10 formed on the one surface of the insulating film 8. Note that the wiring layer 10 includes a portion connected to the anode terminal of the light-emitting element 3 and a portion connected to the cathode terminal of the light-emitting element 3. Those portions are spaced apart from each other.

Between the light-emitting element 3 and the insulating film 8, the intermediate filling layer 12 is filled. Like the insulating film 8, this intermediate filling layer 12 is transparent with respect to the light having the predetermined wavelength given from the light-emitting element 3 to the light-receiving element 4. By implementing the light-emitting element 3 on the insulating film 8 formed on the light-receiving element 4 in this manner, the light-emitting element 3 is mounted on the light-receiving element 4 and the first photocoupling unit is obtained.

The first photocoupling unit has one optical channel formed between the light-emitting element 3 and the light-receiving element 4.

The photocoupling device 1 includes a second photocoupling unit (UNIT 2). The second photocoupling unit includes the light-emitting element 7 (second light-emitting element), the light-receiving element 6 (second light-receiving element), the insulating film 9 (second insulating film), the wiring layer 11, the bump 14, and the intermediate filling layer 13 (second intermediate filling layer).

A construction of the second photocoupling unit is equal to that of the first photocoupling unit. In other words, the light-emitting element 7 corresponds to the light-emitting element 3, the light-receiving element 6 corresponds to the light-receiving element 4, the insulating film 9 corresponds to the insulating film 8, the wiring layer 11 corresponds to the wiring layer 10, and the intermediate filling layer 13 corresponds to the intermediate filling layer 12. Also, a light-emitting surface 7a corresponds to the light-emitting surface 3a and an opposing surface 7b opposing the light-emitting surface 7a corresponds to the opposing surface 3b opposing the light-emitting surface 3a. A light-receiving surface 6a corresponds to the light-receiving surface 4a and an opposing surface 6b opposing the light-receiving surface 6a corresponds to the opposing surface 4b opposing the light-receiving surface 4a.

In this embodiment, the second photocoupling unit is mounted immediately above the first photocoupling unit. In other words, immediately above the light-receiving element 4 constituting the first photocoupling unit, the light-receiving element 6 constituting the second photocoupling unit is mounted. Above the light-receiving element 4 constituting the first photocoupling unit, the light-emitting element 3 is mounted in advance. Also, above the light-receiving element 6 constituting the second photocoupling unit, the light-emitting element 7 is mounted in advance. In other words, by bonding the opposing surface 6b of the second light-receiving element 6 to the opposing surface 4b of the first light-receiving element 4, the second photocoupling unit is mounted immediately above the first photocoupling unit. Accordingly, it becomes possible to prepare a photocoupling block (first photocoupling block) constructed of the first photocoupling unit and the second photocoupling unit with ease. In other words, it becomes possible to construct a first photocoupling block having a plurality of (two, in this embodiment) optical channels while maintaining the small size of the photocoupling device 1. Note that the first photocoupling block is constructed by mounting the second photocoupling unit immediately above the first photocoupling unit and is obtained by laminating the light-emitting element 3, the light-receiving element 4, the light-receiving element 6, and the light-emitting element 7 in this order.

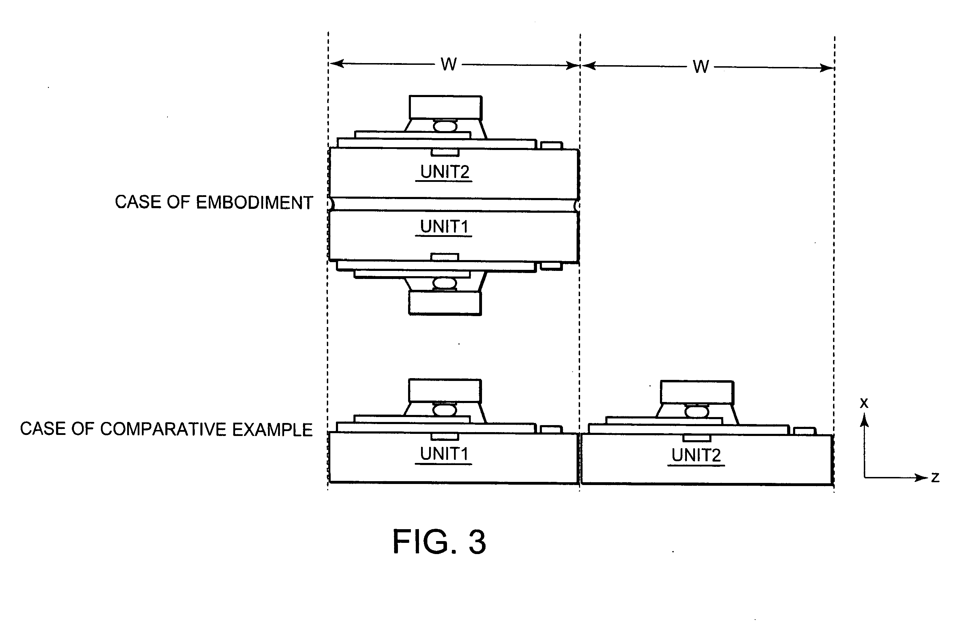

This point will be supplementarily described with reference to FIG. 3. FIG. 3 shows a result of comparison between a width of the photocoupling device 1 (in a direction along a Z axis in FIG. 1) in the case of this embodiment and that of a case of a comparative example. Note that in the comparative example, as shown in FIG. 3, the first photocoupling unit and the second photocoupling unit are arranged side by side.

It should be noted that in FIG. 3, for ease of explanation, reference numerals concerning the photocoupling units are omitted. As to this point, only "UNIT" is explicitly labeled in a substrate portion of each light-receiving element and it is assumed that the construction of the photocoupling units shown in FIG. 3 is the same as that of the photocoupling units shown in FIG. 2.

As shown in FIG. 3, in the case of this embodiment, the width of the photocoupling device 1 is represented as "w". However, the photocoupling device width in the comparative example is represented as "2×w". In other words, with the construction of the first photocoupling block according to this embodiment in which the second photocoupling unit is mounted immediately above the first photocoupling unit, it becomes possible to realize a plurality of optical channels while eliminating an increase of the photocoupling device width.

It should be noted that the construction of the first photocoupling block, in which the second photocoupling unit is mounted immediately above the first photocoupling unit, leads to an increase of an overall thickness (thickness along the X axis). Generally, however, an LED or PD obtained using a semiconductor is extremely thin. Accordingly, it also becomes possible to significantly suppress the overall thickness of the device as compared with a case of a construction described in Japanese Utility Model Registration No. 61-134060 in which photocoupling elements that each have one optical channel are stacked.

Also, the second photocoupling unit is mounted immediately above the first photocoupling unit with the bonding layer 5 in-between. With this construction, the first photocoupling unit and the second photocoupling unit are mechanically sufficiently fixed to each other, so a situation, in which a position of the second photocoupling unit is displaced with respect to the first photocoupling unit, will not occur even when a filling material (resin) is injected through transfer molding or the like.

It is sufficient that the bonding layer 5 is made of a material (bonding material in black or a similar color, for instance) that exhibits a light-shielding property with respect to the light with the predetermined wavelength emitted from the light-emitting element. Note that it is also possible for persons skilled in the art to appropriately select and use another bonding technique (anode junction or the like) that is not based on an adhesive.

Also, the light-receiving element 6, whose chip size is larger than that of the light-emitting element 7, is mounted above the light-receiving element 4 whose chip size is larger than that of the light-emitting element 3. In other words, the opposing surface 6b of the light-receiving element 6 and the opposing surface 4b of the light-receiving element 4 are bonded together. By bonding' together the light-receiving element 4 and the light-receiving element 6 in this manner, it becomes possible to secure a wide bonding area as compared with a case where the light-emitting element 3 and the light-emitting element 7 are bonded together. Accordingly, it becomes possible to make the first photocoupling block constructed of the first photocoupling unit and the second photocoupling unit more mechanically stabilized.

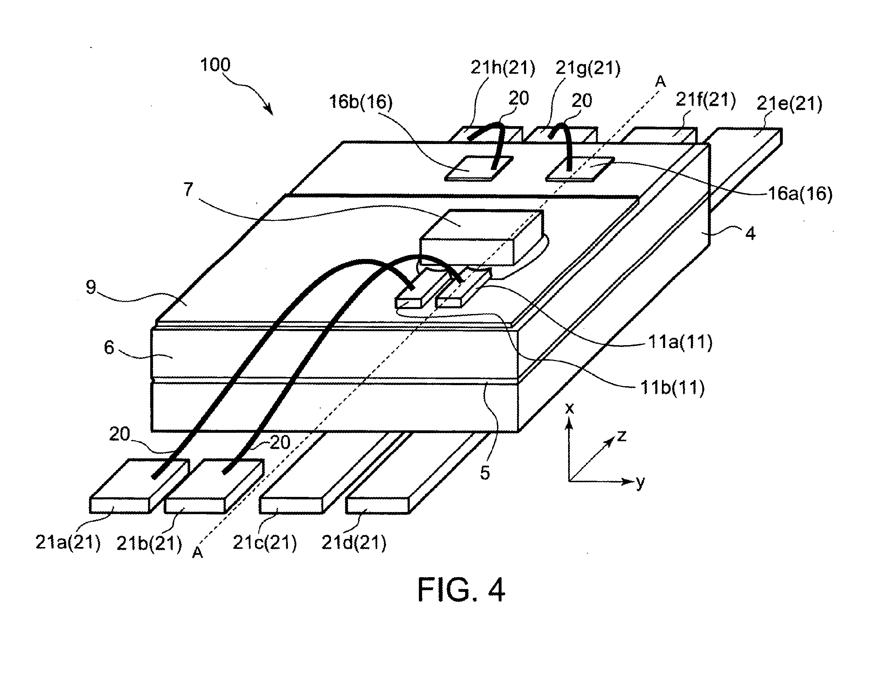

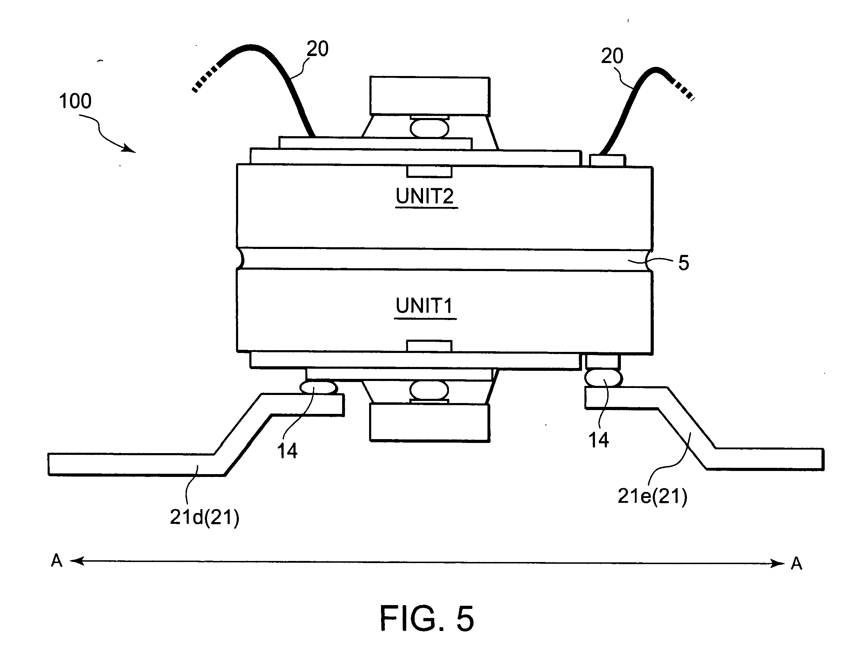

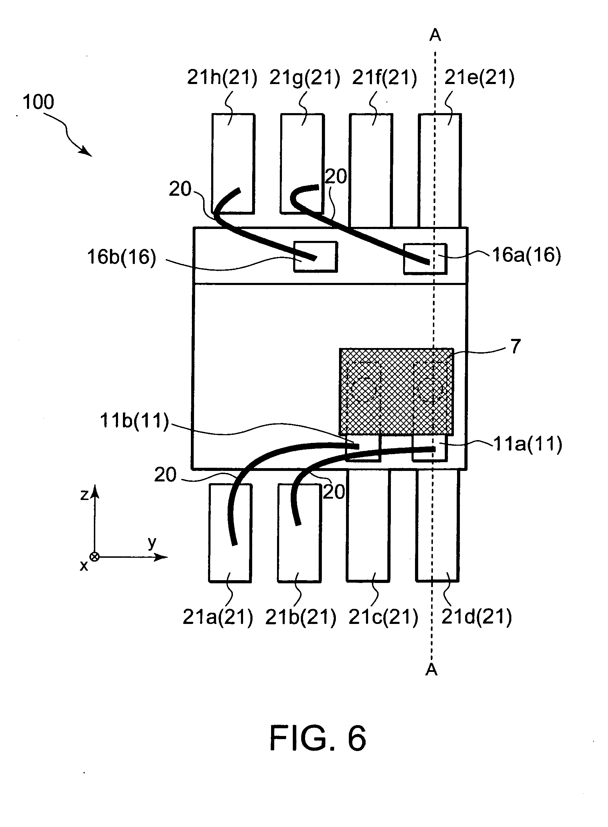

Next, a photocoupling device 100 obtained by arranging the photocoupling device 1 shown in FIG. 1 on a lead frame will be described with reference to FIGS. 4 to 6. Note that FIG. 4 is a perspective view corresponding to FIG. 1 and FIG. 5 is a cross-sectional construction diagram corresponding to FIG. 2. FIG. 6 is a schematic diagram of the photocoupling device shown in FIG. 4 viewed from above.

It should be noted that in FIG. 5, for ease of explanation, reference numerals concerning photocoupling units are omitted. As to this point, only "UNIT" is explicitly labeled in a substrate portion of each light-receiving element and it is assumed that a construction of the photocoupling units shown in FIG. 5 is the same as that of the photocoupling units shown in FIG. 2.

As shown in FIGS. 4 to 6, the photocoupling device 100 has a construction in which the photocoupling device 1 shown in FIG. 1 is mounted on a lead frame 21 made of a metal. The lead frame 21 includes a plurality of land portions 21a to 21h that are electrically insulated from each other.

First, a connection relation between a second photocoupling unit (UNIT 2) and the lead frame 21 will be described with reference to FIG. 6. The land portion 21a is connected to a wiring layer 11b by a wire 20. With this construction, an anode terminal of a light-emitting element 7 is connected to the land portion 21a. The land portion 21b is connected to a wiring layer 11a by a wire 20. With this construction, a cathode terminal of the light-emitting element 7 is connected to the land portion 21b.

The land portion 21g is connected to a cathode terminal 16a of a light-receiving element 6 by a wire 20. The land portion 21h is connected to an anode terminal 16b of the light-receiving element 6 by a wire 20.

The land portions 21a, 21b, 21g, and 21h that function as second land portions give electric connection to the light-emitting element 7 and the light-receiving element 6 that are included in the second photocoupling unit.

In other words, when a bias is applied to the land portions 21a and 21b, the light-emitting element 7 outputs light. Also, when a bias is applied to the land portions 21g and 21h, the light-receiving element 6 converts the light inputted from the light-emitting element 7 into a photocurrent.

Next, a connection relation between a first photocoupling unit (UNIT 1) and the lead frame 21 will be described.

As shown in FIG. 5, the land portion 21d is connected to a wiring layer 11a by a bump 14. With this construction, a cathode of a light-emitting element 3 is connected to the land portion 21d. A connection relation of the land portion 21c is not explicitly shown in the drawing, but the portion 21c is connected to a wiring layer 10 (not shown) formed on an insulating film 8 through a bump (not shown). With this construction, an anode (not shown) of the light-emitting element 3 is connected to the land portion 21c.

As shown in FIG. 5, the land portion 21e is connected to a cathode terminal 16a by a bump 14. With this construction, a cathode of a light-receiving element 4 is connected to the land portion 21e. A connection relation of the land portion 21f is not explicitly shown in the drawing, but the portion 21f is connected to an anode terminal (not shown) of the l.ight-receiving element 4 by a bump (not shown) . As a result, the cathode of the light-receiving element 4 is connected to the land portion 21f.

The land portions 21c, 21d, 21e, and 21f that function as first land portions give electric connection to the light-emitting element 3 and the light-receiving element 4 included in the first photocoupling unit.

In other words, when a bias is applied to the land portions 21c and 21d, the light-emitting element 3 outputs light. Also, when a bias is applied to the land portions 21e and 21f, the light-receiving element 4 converts the light inputted from the light-emitting element 3 into a photocurrent.

As described above, the light-receiving element 6 and the light-emitting element 7 that are included in the second photocoupling unit are each connected to the land portion of the lead frame 21 through the wire. On the other hand, the light-emitting element 3 and the light-receiving element 4 that are included in the first photocoupling unit are each connected to the lead frame 21 through the bump. With this construction, it becomes possible to construct the photocoupling device 100 only with the lead frame arranged in substantially the same plane. In other words, there is no necessity to use a special structure to construct the lead frame 21.

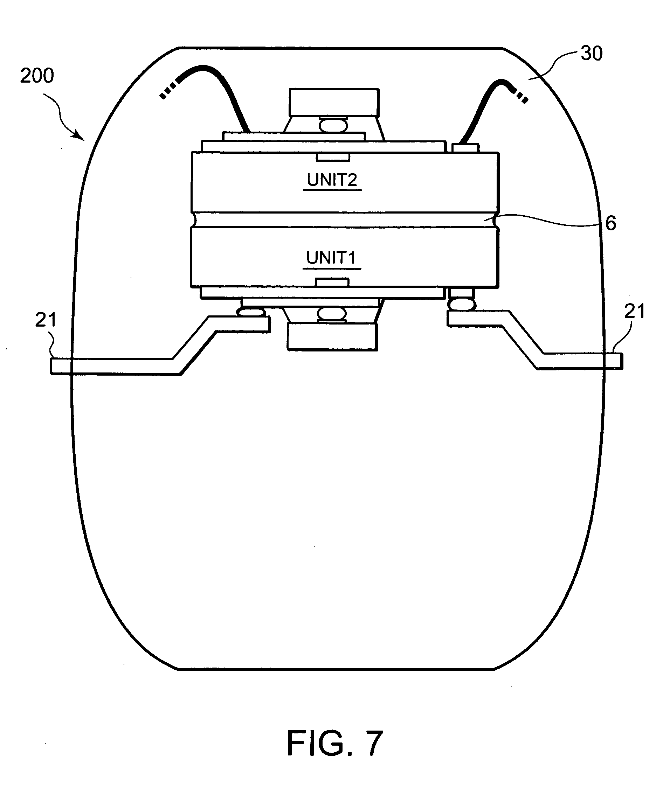

Next, a photocoupling device 200 obtained by molding the photocoupling device 100 shown in FIG. 4 will be described with reference to FIG. 7. Note that in FIG. 7, for ease of explanation, reference numerals concerning photocoupling units are omitted. As to this point, only "UNIT" is explicitly labeled in a substrate portion of each light-receiving element and it is assumed that a construction of the photocoupling units shown in FIG. 7 is the same as that of the photocoupling units shown in FIG. 2.

As shown in FIG. 7, the photocoupling device 200 includes a mold portion 30 made of a filling material such as an epoxy resin. The filling material used to obtain the mold portion 30 is a material having a light-shielding property. In other words, by using a material having a light-shielding property, as the filling material, it becomes possible to suppress a situation in which the light-receiving elements arranged in the photocoupling device 200 malfunction due to disturbance light. Note that by the mold portion 30, crosstalk between an optical channel formed in the first photocoupling unit and an optical channel formed in the second photocoupling unit is reduced to a level at which there is no practical problem.

In the mold portion 30, the whole of the photocoupling device 1 and the wire 20 shown in FIG. 1 is contained. Certain portions of the lead frame 21 are included in the mold portion 30, but other portions of the lead frame 21 exist outside the mold portion 30 in order to secure electric connection with the outside. In other words, the lead frame 21 includes portions exposed from the mold portion 30.

As shown in FIG. 7, the lead frame 21 is arranged in substantially the same plane in the mold portion 30. Here, "substantially the same plane" means that there may be a difference in level to some extent as shown in FIG. 7.

It should be noted that the lead frame is a general term for the plurality of land portions 21a to 21h insulated from each other. Also, there is no necessity to construct the lead frame so as to protrude to the outside of the mold portion 30 as shown in FIG. 7. This is because when the lead frame includes a portion exposed through a surface of the mold portion, it is possible to establish electric contact with another member. The lead frame is preferably constructed of a mono layer made of a metal, but it is also possible for persons skilled in the art to appropriately adopt another structure.

The photocoupling device 200 has a construction in which two photocoupling units are accommodated in the mold portion 30. Accordingly, it becomes possible to sufficiently reduce the overall size of the device as compared with a case where two separately mold-sealed photocoupling units are stacked on each other or are arranged side by side. Also, in the mold portion 30, the second photocoupling unit is mounted immediately above the first photocoupling unit. Accordingly, it becomes possible to sufficiently reduce the size of the element as compared with a case where the photocoupling units are arranged side by side in the mold portion.

Finally, producing steps of the photocoupling device 100 shown in FIG. 4 will be described.

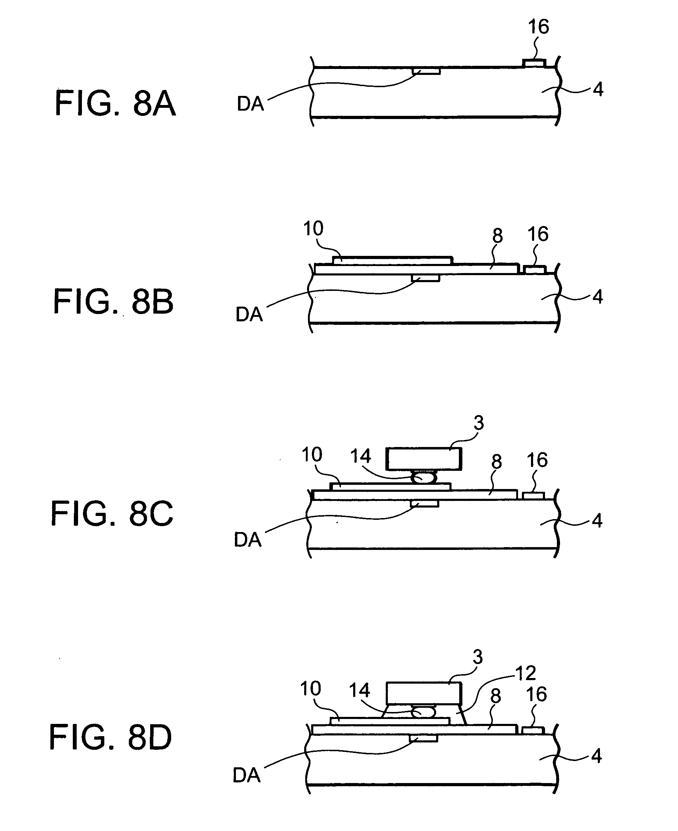

First, steps for producing the first photocoupling unit will be described with reference to FIGS. 8A to 8D. Note that in this embodiment, the construction of the second photocoupling unit is the same as that of the first photocoupling unit, so production of the first photocoupling unit is the equivalent of production of the second photocoupling unit.

First, as shown in FIG. 8A, a plurality of pre-dicing light-receiving elements 4 (hereinafter, simply referred to as "light-receiving elements 4") are formed on a silicon wafer by performing processing, such as impurity diffusion, oxide film deposition, or wiring formation, which is based on an ordinary semiconductor process technique.

Next, as shown in FIG. 8B, the insulating film 8 is formed on the light-receiving surface 4a of each light-receiving element 4. The insulating film 8 is formed by, for instance, depositing an insulating material through sputtering or the like. When the insulating film 8 is formed using a resin material, a lithography technique is applied after the resin material has been spin-coated'onto the light-receiving surface 4a of the light-receiving element 4. After the insulating film 8 has been formed, the wiring layer 10 is formed through sputtering or the like.

Next, as shown in FIG. 8C, after the bump 14 has been arranged at a predetermined position on the wiring layer 10, the light-emitting element 3 is placed on the bump 14. Then, through heating, the light-emitting element 3 is fixed to the wiring layer 10 formed on the insulating film 8. In this manner, the light-emitting element 3 is mounted on the light-receiving element 4.

Next, as shown in FIG. 8D, the intermediate filling layer 12 is injected between the light-emitting element 3 and the light-receiving element 4.

Then, by performing dicing for division into respective chips, a plurality of first photocoupling units are prepared.

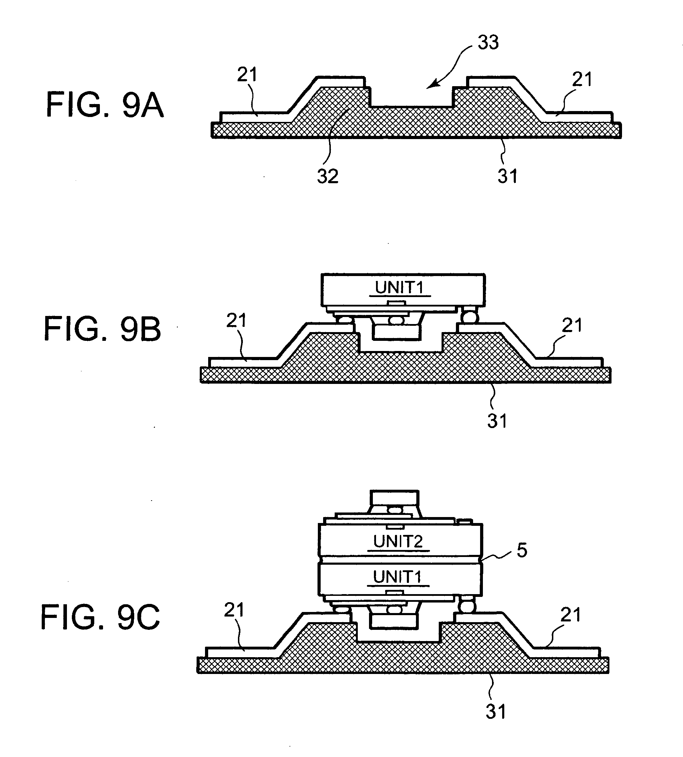

Next, steps for implementing the first photocoupling unit and the second photocoupling unit on the lead frame 21 will be described with reference to FIGS. 9A to 9C.

First, as shown in FIG. 9A, the lead frame 21 is prepared on a heater 31. The heater 31 is a pyroconductive member made of a metal, for instance, and receives supply of heat from a heat source (not shown). An upper surface of the heater includes a convex portion 32 for molding the lead frame. Also, an upper surface of the convex portion 32 includes a concave portion 33 for accommodating the light-emitting element 3 as will be described later. The lead frame 21 may be molded by being sandwiched between another member (not shown) and the heater.

Next, as shown in FIG. 9B, the first photocoupling unit is flip-chip implemented with respect to the lead frame 21. At this time, the lead frame 21 is heated by the heater. Accordingly, the bumps 14 applied to the first photocoupling unit are softened, thereby making it possible to mount the first photocoupling unit on the lead frame 21 as intended.

Next, as shown in FIG. 9C, the bonding layer 5 is produced by pasting an adhesive on one surface (opposing surface opposing the light-receiving surface) of the light-receiving element 4 included in the first photocoupling unit, and then the second photocoupling unit is mounted on the bonding layer 5. At the time of the pasting of the adhesive, the heater 31 stops the heating of the lead frame, so the position of the first photocoupling unit is not displaced with respect to the lead frame.

Then, finally, the terminals of the second photocoupling unit and the lead frame are connected to each other through wires using a bonding device or the like.

It is possible to produce the photocoupling device 100 shown in FIG. 4 in the manner described above. In order to produce the photocoupling device 200 shown in FIG. 7, mold sealing is performed afterward using a sealing technique such as transfer molding.

### <Second Embodiment>

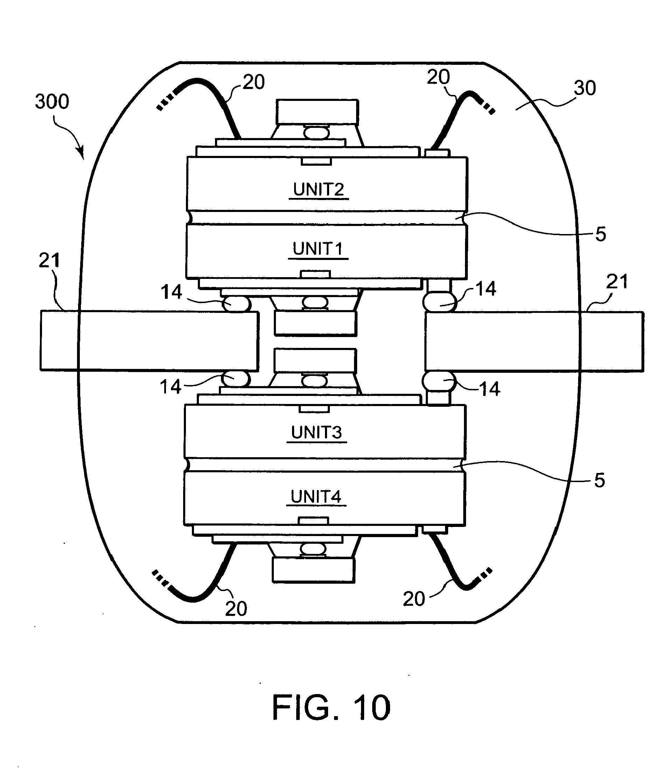

Next, a second embodiment will be described with reference to FIG. 10 that is a schematic diagram of a photocoupling device 300 according to the second embodiment. A different point from the first embodiment lies in the number of photocoupling units included in a mold portion 30. In other words, in this embodiment, the photocoupling device 300 includes four photocoupling units (UNIT 1 to UNIT 4) in the mold portion 30. In other words, the mold portion 30 seals not only a first photocoupling unit and a second photocoupling unit but also a third photocoupling unit and a fourth photocoupling unit. With this construction, as compared with a conventional case, it becomes possible to significantly reduce the size of the photocoupling device regardless of an increase of the number of optical channels.

It should be noted that the third photocoupling unit of this embodiment corresponds to the first photocoupling unit of the first embodiment. Also, the fourth photocoupling unit of this embodiment corresponds to the second photocoupling unit of the first embodiment. A second photocoupling block constructed of the third photocoupling unit and the fourth photocoupling unit is the equivalent of the first photocoupling block constructed of the first photocoupling unit and the second photocoupling unit. A lead frame 21 gives electric connection to a third light-receiving element and a third light-emitting element included in the third photocoupling unit and gives electric connection to a fourth light-receiving element and a fourth light-emitting element included in the fourth photocoupling unit. When the lead frame 21 has been produced using mono-layer metallic wiring, the first photocoupling block and the second photocoupling block may be arranged side by side when viewed in a plain view.

It should be noted that in FIG. 10, for ease of explanation, reference numerals concerning the photocoupling units are omitted. As to this point, only "UNIT" is explicitly labeled in a substrate portion of each light-receiving element and it is assumed that a construction of the photocoupling units shown in FIG. 10 is the same as that of the photocoupling units shown in FIG. 2.

It is apparent that the present invention is not limited to the above embodiments, but may be modified and changed without departing from the scope and spirit of the invention.

## Claims

1. A photocoupling device, comprising:
a first photocoupling unit including a first light-receiving element and a first light-emitting element that are arranged to oppose each other;
a second photocoupling unit including a second light-receiving element and a second light-emitting element that are arranged to oppose each other; and
a lead frame including a first land portion for giving electric connection to the first light-receiving element and the first light-emitting element, and a second land portion for giving electric connection to the second light-receiving element and the second light-emitting element,
wherein the second photocoupling unit is mounted immediately above the first photocoupling unit mounted on the lead frame.

2. A photocoupling device according to claim 1, further comprising a mold portion for sealing the first photocoupling unit and the second photocoupling unit.

3. A photocoupling device according to claim 2, wherein the first land portion and the second land portion are arranged in substantially the same plane in the mold portion.

4. A photocoupling device according to claim 3, wherein:
one of the first light-receiving element and the first light-emitting element is electrically connected to the first land portion through a bump in the mold portion; and
one of the second light-receiving element and the second light-emitting element is electrically connected to the second land portion through a wire in the mold portion.

5. A photocoupling device according to claim 1, wherein the second photocoupling unit is mounted immediately above the first photocoupling unit through bonding of one of an opposing surface opposing a light-receiving surface of the second light-receiving element and an opposing surface opposing a light-emitting surface of the second light-emitting element to one of an opposing surface opposing a light-receiving surface of the first light-receiving element and an opposing surface opposing a light-emitting surface of the first light-emitting element.

6. A photocoupling device according to claim 5, wherein the second photocoupling unit is mounted immediately above the first photocoupling unit through bonding of one of the opposing surface of the second light-receiving element and the opposing surface of the second light-emitting element to one of the opposing surface of the first light-receiving element and the opposing surface of the first light-emitting element through a bonding layer.

7. A photocoupling device according to claim 5, wherein:
the first photocoupling unit is constructed through mounting of the first light-emitting element on the first light-receiving element whose chip size is larger than that of the first light-emitting element; and
the second photocoupling unit is constructed through mounting of the second light-emitting element on the second light-receiving element whose chip size is larger than that of the second light-emitting element.

8. A photocoupling device according to claim 7, wherein:
the first light-emitting element is mounted on the first light-receiving element with a first translucent insulating film having a wiring layer on one surface in-between; and
the second light-emitting element is mounted on the second light-receiving element with a second translucent insulating film having a wiring layer on one surface in-between.

9. A photocoupling device according to claim 2,
wherein the mold portion further seals:
a third photocoupling unit in which a third light-receiving element and a third light-emitting element are arranged to oppose each other; and
a fourth photocoupling unit which is mounted immediately above the third photocoupling unit and in which a fourth light-receiving element and a fourth light-emitting element are arranged to oppose each other.

10. A producing method of a photocoupling device, comprising:
preparing a first photocoupling unit including a first light-receiving element and a first light-emitting element that are arranged to oppose each other;
preparing a second photocoupling unit including a second light-receiving element and a second light-emitting element that are arranged to oppose each other;
preparing a lead frame including a first land portion for giving electric connection to the first light-receiving element and the first light-emitting element, and a second land portion for giving electric connection to the second light-receiving element and the second light-emitting element;
mounting the first photocoupling unit on the lead frame; and
mounting the second photocoupling unit immediately above the first photocoupling unit.

11. A producing method of a photocoupling device according to claim 10, further comprising:
mounting the second photocoupling unit immediately above the first photocoupling unit by bonding one of an opposing surface opposing a light-receiving surface of the second light-receiving element and an opposing surface opposing a light-emitting surface of the second light-emitting element to one of an opposing surface opposing a light-receiving surface of the first light-receiving element and an opposing surface opposing a light-emitting surf ace of the first light-emitting element.

12. A producing method of a photocoupling device according to claim 11, further comprising:
mounting the second photocoupling unit immediately above the first photocoupling unit by bonding one of the opposing surface of the second light-receiving element and the opposing surface of the second light-emitting element to one of the opposing surface of the first light-receiving element and the opposing surface of the first light-emitting element using an adhesive.

13. A producing method of a photocoupling device according to claim 10, further comprising:
mounting the first photocoupling unit on the first land portion of the lead frame through a bump; and
electrically connecting the second photocoupling unit to the second land portion of the lead frame using a wire.

14. A photocoupling device, comprising:
a first photocoupling unit constructed by arranging a first light-receiving element having a light-receiving surface and an opposing surface opposing the light-receiving surface, and a first light-emitting element having a light-emitting surface and an opposing surface opposing the light-emitting surface, to oppose each other; and
a second photocoupling unit constructed by arranging a second light-receiving element having a light-receiving surface and an opposing surface opposing the light-receiving surface, and a second light-emitting element having a light-emitting surface and an opposing surface opposing the light-emitting surface, to oppose each other,
wherein one of the opposing surface of the second light-receiving element and the opposing surface of the second light-emitting element is bonded to one of the opposing surface of the first light-receiving element and the opposing surface of the first light-emitting element.

15. A photocoupling device according to claim 14,
wherein the first photocoupling unit and the second photocoupling unit construct a first photocoupling block which is mounted on a lead frame including a first land portion for giving electric connection to the first light-receiving element and the first light-emitting element, and a second land portion for giving electric connection to the second light-receiving element and the second light-emitting element.
